# EUROPEAN PATENT SPECIFICATION

(11) **EP 2 036 125 B1**
(45) Date of publication and mention of the grant of the patent: **22.05.2019**
(21) Application number: 07789762.7
(22) Date of filing: 20.06.2007
(51) Int. Cl.: H01L 23/485

(54) **FLIP-CHIP INTERCONNECTION WITH FORMED COUPLINGS**
FLIP-CHIP-VERBINDUNG MIT GEFORMTEN KUPPLUNGEN
INTERCONNEXION PAR BILLES À FORMATIONS DE CONNEXIONS

(30) Priority: 26.06.2006 US 805760 P
(43) Date of publication of application: 18.03.2009
(73) Proprietor: Koninklijke Philips N.V., 5656 AE Eindhoven (NL)
(72) Inventor: SUDOL, Wojtek, Briarcliff Manor, New York 10510-8001 (US); WILSON, Martha, Briarcliff Manor, New York 10510-8001 (US)
(74) Representative: de Haan, Poul Erik
(86) International application number: PCT/IB2007/052390
(87) International publication number: WO 2008/001283

(56) References cited:
- WO-A-01/68311
- WO-A-2006/018805
- WO-A1-2004/052209
- US-A- 6 137 184
- US-A1- 2003 067 084
- US-A1- 2004 227 256
- US-A1- 2005 096 546
- US-A1- 2005 218 513
- US-B1- 6 178 249
- US-B1- 6 396 155

## Description

The present system relates to an interconnection method and device that uses a flip-chip type of electrical interconnection with a formed electrical pad connection.

Current state of the art integrated circuits (ICs) are continuously shrinking in size and increasing in complexity. As density of components increases, the system of electrically coupling components has become critical in that the physical interconnections occupy a signification portion of available surface area reducing the ability to position electrical circuitry within this area.

An electrical interconnection technology is known wherein one portion of the interconnection is formed by a contact bump and another portion of the interconnection is formed by a contact pad. The pad provides a means of making electrical connection. The bump also provides a means of making an electrical connection but also has a substantial height to provide a physical separation between connecting substrates. Typically, the bump is produced on the surface of the ASIC and the pad is positioned on the bottom of the acoustic element. During the manufacturing process, the bump and pad are brought into contact with each other to form the electrical interconnection. U.S. patent No. 6,015,652, discloses a type of such an interconnection system termed "flip-chip bonding" for ICs mounted on a substrate. This typical interconnection system alleviates some of the problems associated with other electrical interconnection systems, yet still occupies much of available surface area that might otherwise be utilized for electronic components. This problem is exacerbated further when the electrical interconnection is made directly to an integrated circuit, such as an application-specific integrated circuit (ASIC).

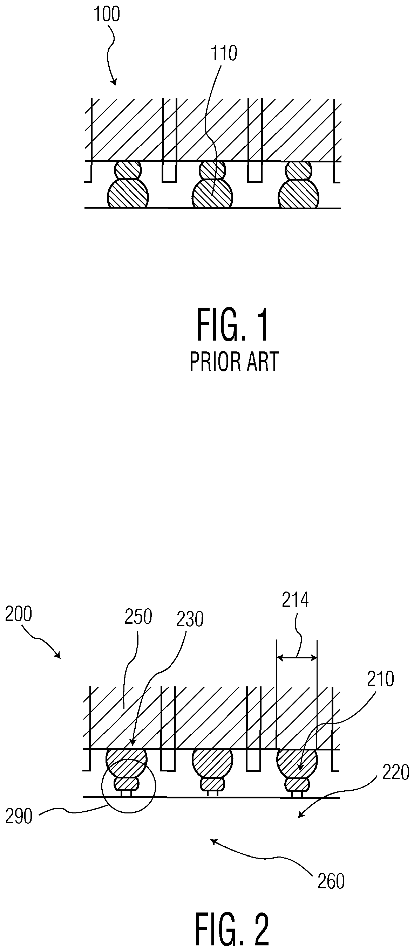

PCT Patent Application WO 2004/052209 discloses a system of electrically coupling an ASIC to a plurality of acoustic elements for the purposes of forming a miniaturized transducer. In the shown system, the bump is electrically coupled to one of the acoustic element or ASIC and the pad is electrically coupled to the other of the acoustic element or ASIC. This system realizes a small electrical package that for example, may be formed to create an ultrasonic transducer that may be utilized for transesophageal, laparoscopic and intra-cardiac examination. Nonetheless, since these products adopt a pitch match of the cell circuitry directly under the acoustic element, it is desirable to reduce the pitch further. The current mixed-signal ASIC processes and voltages that are needed for proper operation still limit further reduction of the acoustic element and control circuitry. For example, for a flip-chip interconnection system 100 using stud-shaped bumps 110, such as shown in FIG. 1, positioned on a 185 um pitch array, approximately 40% of the area of the ASIC is not usable for circuitry due to these bumps. The pads or surfaces that electrically interconnect to the bumps are typically larger laterally across a surface that contacts the bump than a contacting surface of the bump. In other words, the bump surface that makes an electrical interconnection with the pad is smaller than a corresponding contacting surface on the pad.

WO 2001/068311 A1 discloses a flip chip structure that is formed by mechanically interlocking joining surfaces of a first and a second element. WO 2006/018805 A1 discloses an ultrasound transducer comprising an integrated circuit and an array of acoustic elements coupled to the integrated circuit via flip chip bumps. The flip chip bumps comprise high aspect ratio bumps having an aspect ratio greater than 1:1.

US 2004/0227256 A1 relates to a semiconductor device including a film substrate having an interconnection pattern provided on a surface thereof, a semiconductor chip mounted on the film substrate and having an electrode provided on a surface thereof, and an insulative resin portion provided between the film substrate and the semiconductor chip.

US 2003/0067084 A1 describes a semiconductor device that is arranged in such a way that a semiconductor chip having electrodes is flip chip mounted on printed substrate pads on a printed wiring substrate by means of a bump formed on each electrode. The semiconductor chip and the printed wiring substrate are fixed with a thermo-setting resin.

WO 2004/052209 A1 is related to ultrasonic transducers having a reduced size in comparison with prior art ultrasonic transducers and including a thermally-conductive body, a flexible circuit bent at least partially around the body, an acoustic assembly arranged on the flexible circuit and electronic components for controlling the acoustic assembly to transmit and receive ultrasonic waves.

US 6,178,249 B1 relates to a method for attaching a micromechanical microphone to be used in connection with a mobile station to a substrate, in which a diaphragm and back electrode for the microphone are placed within a distance of each other, wherein an air gap is formed between the diaphragm and the back electrode. The microphone is attached to the substrate with fixing means, wherein the volume of the back chamber is adjusted by adjusting the height of the fixing means. The substrate is an ASIC and the microphone is coupled to the ASIC by means of bumps in a flip-chip arrangement.

US 2005/096546 A1 discloses a reconfigurable ultrasound array that allows groups of subelements to be connected together dynamically so that the shape of the resulting element can be made to match the shape of the wave front.

It is an object of the present system to overcome disadvantages and/or make improvements in the prior art. It is an object of the present system to provide ways to reduce the pitch using chip fabrication techniques that are achievable using, for example, typical ASIC technology.

In accordance with the present system, a flip-chip electrical coupling is formed between first and second electrical components. The coupling includes a bump and a pad. The bump is electrically coupled to the first electrical component. The pad is electrically coupled to the second electrical component. The pad is electrically coupled to and dimensioned smaller than a corresponding coupling surface of the bump. The second electrical component is an ASIC, the ASIC having circuitry positioned below the pad. In one embodiment not according to the invention, the pad and bump may be electrically coupled together using an ultrasonic stub bump bonding process. According to the invention the pad and bump are electrically coupled together using conductive epoxy. The bump may be stud-shaped, ball-shaped, etc.

In the same or another embodiment, the first electrical component may be an acoustic element. The coupling may be one of a plurality of electrical couplings present in a pitch array of less than 150 um.

The following are descriptions of illustrative embodiments that when taken in conjunction with the following drawings will demonstrate the above noted features and advantages, as well as further ones. In the following description, for purposes of explanation rather than limitation, specific details are set forth such as the particular architecture, interfaces, techniques, etc., for illustration. Moreover, for the purpose of clarity, detailed descriptions of well-known devices, circuits, and methods are omitted so as not to obscure the description of the present system.

It should be expressly understood that the drawings are included for illustrative purposes and do not represent the scope of the present system. In the accompanying drawings, like reference numbers in different drawings designate similar elements.
FIG. 1 shows a prior art flip-chip interconnection system;
FIG. 2 shows an illustrative cross-section of a flip-chip interconnection in accordance with an embodiment of the present system; and
FIG. 3 shows a detailed cross-sectional area section 290 of the illustrative flip-chip interconnection system 200 shown in FIG. 2 in accordance with an embodiment of the present system.

FIG. 2 shows an illustrative cross-section of a flip-chip interconnection system 200 in accordance with an embodiment of the present system. In this embodiment, a high aspect bump 210 is shown in a form of a stud bump that during fabrication is electrically coupled to a de-matching layer surface 230 of an electrical component, such as an acoustic element 250. The bump may be in any form including a ball, stud or other shape that may be suitably applied. The acoustic element may be of a type for generating ultrasonic energy emissions as may be useful in an ultrasonic transducer application.

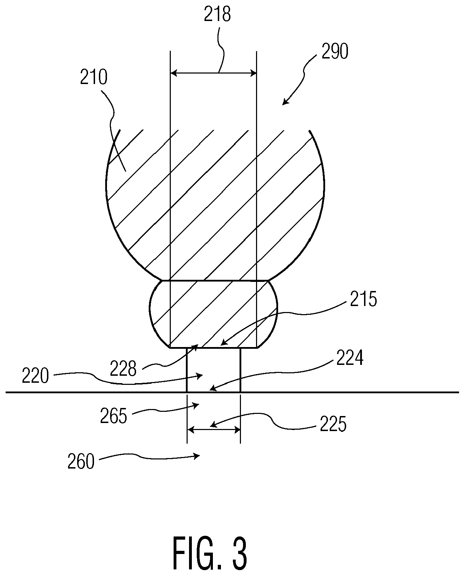

FIG. 3 shows a detailed cross-sectional area section 290 of the illustrative flip-chip interconnection system 200 shown in FIG. 2 in accordance with an embodiment of the present system. The bump 210 may be fabricated using any fabrication process, such as plating, machining, forming, electro-lithography, wire bonding, or any other fabrication process that may be suitably applied. In one application, the bump 210 height may be in the range of 50-150 um high, such as 100 um high, and have a contacting surface 214 electrically coupled with the acoustic element 250, and having a diameter in the range of 50-120 um, such as 70 um. The height of the bump 210 helps provide a physical separation between connecting substrates, such as the acoustic element 250 and the ASIC 260.

In accordance with an embodiment of the present system, an IC, such as ASIC 260, has contact pads 220, which are electrically coupled to the ASIC 260 through a contacting surface 224 of the pads 220. The electrical coupling may be provided through a contact metallization layer 265 of the ASIC 260 or any other system for providing electrical interconnection between the contact pad 220 and the ASIC 260. In one embodiment, the pads 220 may have a diameter 225 in the range of 10-70 um, such as a diameter of 20 um and a height in the range of 1-30 um, such as a height of 15 um. The pads 220 may be formed by any forming and/or deposition process including electrolysis plating, sputtering, photo-deposition, or other system that may be suitably applied. In one embodiment, the pads 220 may be formed simply utilizing electrolysis plating of gold as may be readily achieved using low-cost metallurgical techniques.

In accordance with the present system, the pad 220 is formed having a small diameter 225 as compared to a contacting surface 215 of the bump 210. For example, the contacting surface 215 may have a diameter 218 in the range of 40-80 um, such as a diameter of 50 um. By forming a relatively small diameter pad 220 on the ASIC 260, a larger portion of the ASIC surface area may be utilized for circuitry as opposed to prior systems. For example, the present system of interconnection may be suitably applied in fine-pitched arrays of 150 um and less. In a further embodiment not according to the invention, electrical coupling between the bump 210 contacting surface 215 and the pad 220 contacting surface 228 may be brought about using low temperature and pressure bonding techniques, such as ultrasonic stub bump bonding. This technique has the added advantage that since low pressure is utilized between the bonding surfaces (e.g., between the bump and pad), the area of the ASIC 260 below the pad 220 (e.g., below the top metallization layer 265 of the ASIC 260) may be utilized for circuitry and accordingly, may result in more useable area of the ASIC than in prior systems. According to the invention, the pad 220 and the bump 210 are electrically coupled together using conductive epoxy.

In addition, it should be readily appreciated that although in the illustrative embodiment, three acoustic elements 250 are shown with three interconnection systems (e.g., bump 210 and pad 220), more or less may be utilized depending on a desired application. The acoustic elements 250 may be of any type and configuration including a configuration that facilitates 3-dimensional (3-D) imaging such as may be utilized for a 3-D ultrasonic imaging application and/or matrix transducer configurations.

Of course, it is to be appreciated that any one of the above embodiments or processes may be combined with one or with one or more other embodiments or processes to provide even further improvements in accordance with the present system.

In interpreting the appended claims, it should be understood that:
a) the word "comprising" does not exclude the presence of other elements or acts than those listed in a given claim;
b) the word "a" or "an" preceding an element does not exclude the presence of a plurality of such elements;
c) any reference signs in the claims do not limit their scope;
d) several "means" may be represented by the same item or hardware or software implemented structure or function;
e) any of the disclosed elements may be comprised of hardware portions (e.g., including discrete and integrated electronic circuitry), software portions (e.g., computer programming), and any combination thereof;
f) hardware portions may be comprised of one or both of analog and digital portions;
g) any of the disclosed devices or portions thereof may be combined together or separated into further portions unless specifically stated otherwise; and
h) no specific sequence of acts or steps is intended to be required unless specifically indicated.

## Claims

1. A flip-chip electrical coupling between first and second electrical components (250, 260), the coupling comprising:
a bump (210) comprising first and second electrical contacting surfaces (214, 215), wherein the first contacting surface (214) of the bump (210) is electrically coupled to the first electrical component (250); and
a pad (220) comprising first and second electrical contacting surfaces (224, 228), wherein the first contacting surface (224) of the pad (220) is electrically coupled to the second electrical component (260) and the second electrical contacting surface (228) of the pad (220) is electrically coupled to and dimensioned smaller than the second electrical contacting surface (215) of the bump (210), and
wherein the second electrical component (260) is an ASIC,
wherein the ASIC is having circuitry positioned below the pad (220),
wherein the bump portion (210) is coupled to the pad portion (220) by conductive epoxy.

2. The coupling of Claim 1, wherein the bump (210) is a stud-shaped bump.

3. The coupling of Claim 1, wherein the bump (210) is a ball-shaped bump.

4. The coupling of Claim 1, wherein the bump (210) is configured with a bump height in the range of 50-150 um.

5. The coupling of Claim 1, wherein the first coupling surface (214) of the bump has a diameter in the range of 50-120 um.

6. The coupling of Claim 1, wherein the pad (220) is configured having a diameter in the range of 10-70 um.

7. The coupling of Claim 1, wherein the first electrical component (250) is an acoustic element.

8. The coupling of Claim 1, wherein the coupling is configured as one of a plurality of electrical couplings in a pitch array of less than 150 um.

9. A method for forming a flip-chip electrical coupling between first and second electrical components (250, 260), the second electrical component (260) being an ASIC, wherein the ASIC is having circuitry positioned below the pad (220), the process comprising the acts of:
coupling a bump portion (210) to the first electrical component (250);
coupling a pad portion (220) to the second electrical component (260); and
coupling the bump portion (210) to the pad portion (220), wherein a surface (228) of the pad portion (220) that is coupled to the bump portion (210) is dimensioned smaller than a corresponding contacting surface (215) of the bump portion (210),
wherein the act of coupling the bump portion (210) to the pad portion (220) is performed using conductive epoxy.

10. The method of Claim 9, comprising the act of forming the bump portion (210) as a stud-shaped bump portion.

11. The method of Claim 9, comprising the act of forming the bump portion (210) having a bump height in the range of 50-150 um and a surface (214) coupled to the first electrical component (250) having a diameter in the range of 50-120 um.

12. The method of Claim 9, comprising the act of forming the pad portion (220) having a diameter in the range of 10-70 um.

13. The method of Claim 9, comprising the act of forming the flip chip electrical coupling as one of a plurality of electrical couplings formed within a pitch array of less than 150 um.

## Patentansprüche

1. Elektrische Flip-Chip-Kopplung zwischen ersten und zweiten elektrischen Komponenten (250, 260), wobei die Kopplung umfasst:
einen Höcker (210), der erste und zweite elektrische Kontaktoberflächen (214, 215) umfasst, wobei die erste Kontaktoberfläche (214) des Höckers (210) elektrisch mit der ersten elektrischen Komponente (250) gekoppelt ist; und
eine Kontaktstelle (220), umfassend eine erste und eine zweite elektrische Kontaktoberfläche (224, 228), wobei die erste Kontaktoberfläche (224) der Kontaktstelle (220) elektrisch mit der zweiten elektrischen Komponente (260) gekoppelt ist und die zweite elektrische Kontaktoberfläche (228) der Kontaktstelle (220) elektrisch mit der zweiten elektrischen Kontaktoberfläche (215) des Höckers (210) gekoppelt und kleiner dimensioniert als diese ist, und wobei die zweite elektrische Komponente (260) eine ASIC ist, wobei die ASIC eine Schaltungsanordnung aufweist, die unter der Kontaktstelle (220) positioniert ist,
wobei der Höckerabschnitt (210) durch leitendes Epoxid mit dem Kontaktstellenabschnitt (220) gekoppelt ist.

2. Kopplung nach Anspruch 1, wobei der Höcker (210) ein zapfenförmiger Höcker ist.

3. Kopplung nach Anspruch 1, wobei der Höcker (210) ein kugelförmiger Höcker ist.

4. Kopplung nach Anspruch 1, wobei der Höcker (210) mit einer Höckerhöhe im Bereich von 50-150 um konfiguriert ist.

5. Kopplung nach Anspruch 1, wobei die erste Kopplungsoberfläche (214) des Höckers einen Durchmesser im Bereich von 50-120 um hat.

6. Kopplung nach Anspruch 1, wobei die Kontaktstelle (220) mit einem Durchmesser im Bereich von 10-70 um konfiguriert ist.

7. Kopplung nach Anspruch 1, wobei die erste elektrische Komponente (250) ein akustisches Element ist.

8. Kopplung nach Anspruch 1, wobei die Kopplung als eine von einer Vielzahl von elektrischen Kopplungen in einem Pitch-Array von weniger als 150 um konfiguriert ist.

9. Verfahren zum Bilden einer elektrischen Flip-Chip-Kopplung zwischen der ersten und der zweiten elektrischen Komponente (250, 260), wobei die zweite elektrische Komponente (260) eine ASIC ist, wobei die ASIC eine Schaltungsanordnung aufweist, die unter der Kontaktstelle (220) positioniert ist, wobei der Prozess die folgenden Aktionen umfasst:
Koppeln eines Höckerabschnitts (210) an die erste elektrische Komponente (250);
Koppeln eines Kontaktstellenabschnitts (220) an die zweite elektrische Komponente (260); und
Koppeln des Höckerabschnitts (210) an den Kontakstellenabschnitt (220), wobei eine Oberfläche (228) des Kontaktstellenabschnitts (220), die mit dem Höckerabschnitt (210) gekoppelt ist, kleiner dimensioniert ist als eine entsprechende Kontaktoberfläche (215) des Höckerabschnitts (210),
wobei die Aktion des Koppelns des Höckerabschnitts (210) an den Kontaktstellenabschnitt (220) unter Verwendung eines leitfähigen Epoxids erfolgt.

10. Verfahren nach Anspruch 9, umfassend die Aktion des Ausbildens des Höckerabschnitts (210) als einen zapfenförmigen Höckerabschnitt.

11. Verfahren nach Anspruch 9, umfassend die Aktion des Ausbildens des Höckerabschnitts (210) mit einer Höckerhöhe im Bereich von 50-150 um und einer Oberfläche (214), die mit der ersten elektrischen Komponente (250) gekoppelt ist und einen Durchmesser in dem Bereich von 50-120 um aufweist.

12. Verfahren nach Anspruch 9, umfassend die Aktion des Ausbildens des Kontaktstellenabschnitts (220) mit einem Durchmesser im Bereich von 10-70 um.

13. Verfahren nach Anspruch 9, umfassend die Aktion des Ausbildens der elektrischen Flip-Chip-Kopplung als eine von einer Vielzahl von elektrischen Kopplungen, die innerhalb eines Pitch-Arrays von weniger als 150 um ausgebildet werden.

## Revendications

1. Couplage électrique par billes entre des premier et second composants électriques (250, 260), le couplage comprenant :
une bosse (210) comprenant des première et seconde surfaces de contact électrique (214, 215), dans lequel la première surface de contact (214) de la bosse (210) est couplée électriquement au premier composant électrique (250) ; et
une plage (220) comprenant des première et seconde surfaces de contact électrique (224, 228), dans lequel la première surface de contact (224) de la plage (220) est couplée électriquement au second composant électrique (260) et la seconde surface de contact électrique (228) de la plage (220) est couplée électriquement à la seconde surface de contact électrique (215) de la bosse (210) et est de dimensions plus petites que celle-ci, et
dans lequel le second composant électrique (260) est un ASIC,
dans lequel l'ASIC a des circuits positionnés sous la plage (220),
dans lequel la partie de bosse (210) est couplée à la partie de plage (220) par un époxy conducteur.

2. Couplage selon la revendication 1, dans lequel la bosse (210) est une bosse en forme de goujon.

3. Couplage selon la revendication 1, dans lequel la bosse (210) est une bosse en forme de bille.

4. Couplage selon la revendication 1, dans lequel la bosse (210) est configurée avec une hauteur de bosse dans la plage de 50 à 150 um.

5. Couplage selon la revendication 1, dans lequel la première surface de couplage (214) de la bosse a un diamètre dans la plage de 50 à 120 um.

6. Couplage selon la revendication 1, dans lequel la plage (220) est configurée avec un diamètre dans la plage de 10 à 70 um.

7. Couplage selon la revendication 1, dans lequel le premier composant électrique (250) est un élément acoustique.

8. Couplage selon la revendication 1, dans lequel le couplage est configuré sous la forme de l'un d'une pluralité de couplages électriques dans un réseau de pas de moins de 150 um.

9. Procédé de formation d'un couplage électrique à billes entre des premier et second composants électriques (250, 260), le second composant électrique (260) étant un ASIC, dans lequel l'ASIC comporte des circuits positionnés sous la plage (220), le procédé comprenant les étapes consistant à :
coupler une partie de bosse (210) au premier composant électrique (250) ;
coupler une partie de plage (220) au second composant électrique (260) ; et
coupler la partie de bosse (210) à la partie de plage (220), dans lequel une surface (228) de la partie de plage (220) qui est couplée à la partie de bosse (210) a des dimensions plus petite qu'une surface de contact correspondante (215) de la partie de bosse (210),
dans lequel l'étape consistant à coupler la partie de bosse (210) à la partie de plage (220) est effectuée à l'aide d'un époxy conducteur.

10. Procédé selon la revendication 9, comprenant l'étape consistant à former la partie de bosse (210) sous la forme d'une partie de bosse en forme de goujon.

11. Procédé selon la revendication 9, comprenant l'étape consistant à former la partie de bosse (210) ayant une hauteur de bosse dans la plage de 50 à 150 um et une surface (214) couplée au premier composant électrique (250) ayant un diamètre dans la plage de 50 à 120 um.

12. Procédé selon la revendication 9, comprenant l'étape consistant à former la partie de plage (220) ayant un diamètre dans la plage de 10 à 70 um.

13. Procédé selon la revendication 9, comprenant l'étape consistant à former le couplage électrique à billes sous la forme d'un couplage parmi une pluralité de couplages électriques formés dans un réseau de pas de moins de 150 um.
